# EUROPÄISCHE PATENTANMELDUNG

(11) **EP 4 290 718 A1**
(43) Veröffentlichungstag der Anmeldung: **13.12.2023**
(21) Anmeldenummer: 23178141.0
(22) Anmeldetag: 07.06.2023
(51) Int. Cl.: H02H 3/04, G01R 31/327, H02H 3/05, H03K 17/689, H03K 17/785, H02H 3/08, H02H 3/32

(54) **SICHERES HALBLEITERRELAIS**

(30) Priorität: 09.06.2022 DE 102022114513
(71) Anmelder: Wieland Electric GmbH, 96052 Bamberg (DE)
(72) Erfinder: Bilz, Falko, 14612 Falkensee (DE)
(74) Vertreter: 2K Patentanwälte Blasberg Kewitz & Reichel

(57) **Zusammenfassung**

Ein Sicherheitsschaltgerät, ausgelegt zum gemäß einer Sicherheitsvorschrift sicheren Ein- und Ausschalten eines elektrischen Verbrauchers, umfassend einen Leistungskreis mit zumindest zwei in Reihe geschalteten Halbleiterschaltelementen (S1, S2), einem Ausgang (K2), an den der elektrische Verbraucher (RL25) unter Bildung eines mittels der Halbleiterschaltelemente (S1, S2) sicher schaltbaren Versorgungsstromkreises für den elektrischen Verbraucher anschließbar ist, weiter umfassend ein Mess- und Auswertesystem zur Prüfung der Funktionalität der Halbleiterschaltelemente mittels Spannungsmessgeräten, ausgebildet zur Messung der Spannung über das jeweilige Halbleiterschaltelement (S1, S2), soll eine galvanische Trennung der Leistungskreise untereinander ermöglichen. Dazu weist es ein Schaltelement (S3) zur Bildung eines Strompfades parallel zum Verbraucher (RL25), welcher die Halbleiterschaltelemente umfasst, auf, und die Schaltkontakte der Halbleiterschaltelemente sind galvanisch getrennt (TR1-TR3) angesteuert.

## Beschreibung

Die Erfindung betrifft Verfahren und Vorrichtungen für sichere Ausgänge in Steuerungen mit funktionaler Sicherheit ohne Verwendung mechanischer Relais, wobei Steuer- und Leistungskreis galvanisch voneinander getrennt sind.

EP2876509B1 beschreibt einen funktional sicheren Schalter, der Leitungsfehler im Ausgangsstromkreis durch ein geeignetes Stromessverfahren erkennt. Eine galvanische Trennung der elektrischen Ansteuerung ist zusätzlich möglich, wird jedoch nicht vollständig offenbart. Lediglich die Kondensatoren 48 erlauben zusammen mit einem hochohmigen Widerstand 52 in Fig. 5 in EP2876509B1 eine zumindest hochohmige Trennung.

Anmerkung: In Fig. 5 in EP2876509B1 ist die Diode 56 in verkehrter Polarität dargestellt.

Es kann gewünscht sein, dass auch die Leistungskreise untereinander galvanisch getrennt sind und diese deshalb ab der galvanisch trennenden Einrichtung auf der Leistungsseite separat aufgebaut sind. In EP2876509B1 werden Ausgangstreiber 22 beschrieben, wobei diese in den Ansprüchen nicht genannt sind und bei galvanischer Trennung der Leistungskreise nicht erforderlich sind. In EP2876509B1 sind die Schaltelement 18, 20 redundant parallel verschaltet ausgeführt, um die enthaltenen Schalter 28, 30, 32, 34 auch im eingeschalteten Zustand einzeln testen zu können. Ist nur der Test im ausgeschalteten Zustand erforderlich, kann eines der zwei Schaltelemente zusammen mit der zugehörigen Strommesseinrichtung 36 bzw. 38 weggelassen werden.

Die Schaltersymbole in EP2876509B1 sind nur für eine unidirektionale Stromleitung geeignet. Feldeffekttransistoren haben konstruktionsbedingt eine sogenannte Body-Diode zwischen Source und Drain und sind deshalb in umgekehrter Polarität zumindest abzüglich der Dioden-Flusspannung stets leitend. Zum Schalten von Wechselstrom (AC) sind deshalb geeignetere Schalter bzw. Schalterkombinationen vorzusehen. IGBTs und Bipolartransistoren haben keine Body-Diode zwischen Emitter und Kollektor, leiten jedoch den Leistungsstrom nur in einer Richtung.

Aus den Zeitverläufen von Stromverbräuchen lassen sich unterschiedlichste Aussagen ableiten, was als Zusatznutzen ab Abschnitt [0020] sowie ab Abschnitt [0040] grundsätzlich offenbart wird. Insbesondere für die zunehmenden KI-Anwendungen kann die Aufnahme von Stromverbräuchen dienlich sein. Für eine bidirektionale Kommunikation mit externen Komponenten sind bereits Schaltausgänge 14 sowie Schalteingänge 16 in EP2876509B1 offenbart.

Die Ansteuerung der Schalter erfolgt galvanisch getrennt. Die erfolgt bevorzugt durch induktive Kopplung (Transformatorprinzip), optische Kopplung (Optokopplerprinzip) oder kapazitive Kopplung.

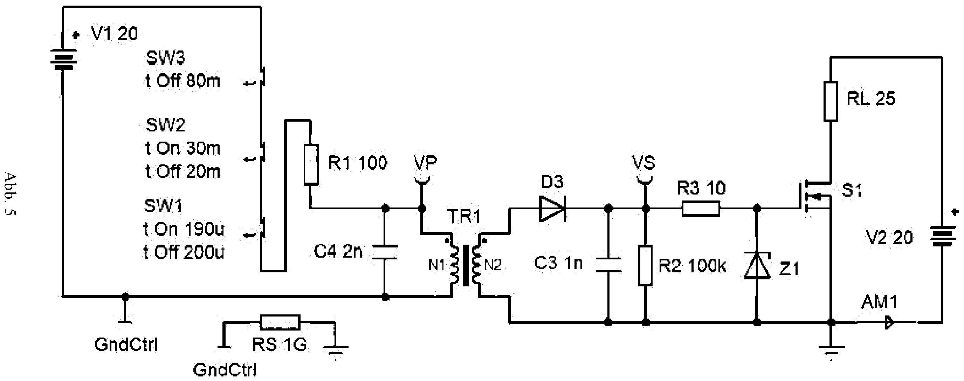

Die induktive Kopplung hat den Vorteil, Energie von der Steuer- auf die Steuerseite zu übertragen. Mit einer geeigneten Zusatzschaltung kann eine Spannung für beispielsweise die Gate-Ansteuerung eines Feldeffekttransistors oder IGBTs (Insulated-Gate Bipolar Transistor) oder der Basisstrom zur Ansteuerung eines Bipolartransistors generiert werden. Für die Gate-Ansteuerung besteht diese Zusatzschaltung auf der Leistungsseite vorteilhafterweise aus einer Gleichrichterdiode, einem Kondensator und eine die Gate-Spannung begrenzende Z-Diode entsprechend Abbildung 5.

Auf der Ansteuerseite sorgt ein kurzer Zeitraum, in dem der Primärinduktivität des Transformators Strom zugeführt wird, für eine möglichst geringe Sättigung des Übertragermaterials des Transformators. Stand der Technik und nicht näher dargestellt ist ein zusätzlich in Reihe zur Primärinduktivität geschalteter Kondensator. Ein optionaler zusätzlicher parallel zur Primärinduktivität geschalteter Kondensator bildet einen Schwingkreis, der durch die gepulste Ansteuerung angeregt wird. Die stets vorhandene parasitäre Kapazität einer real aufgebauten Primärwicklung hat einen vergleichbaren Effekt. Durch die relativ hohe Frequenz des Schwingkreises ist die Leistungsdichte des Transformators relativ hoch.

Bei der optischen Kopplung wird ebenfalls Strahlungsenergie von der Steuer- auf die Steuerseite übertragen. Stand der Technik und dem Fachmann bekannt sind Bauelemente, die auf der Empfängerseite eine ausreichend hohe Spannung zur Ansteuerung von Schaltern bereitstellen, beispielhaft durch in Reihe geschaltete Photodioden auf der Empfangsseite, weshalb auf eine grafische Darstellung und textuelle Beschreibung zur Verwendung und Beschaltung dieser Bauelemente verzichtet werden kann. Prinzipiell kann der in den Abbildungen gezeigte Transformator durch das optisch koppelnde Element ausgetauscht werden. Dioden zur Gleichrichtung sowie Kondensatoren zur Begünstigung von Schwingungen zusammen mit den Induktivitäten des Transformators können dabei entfallen.

Dem Fachmann sind galvanisch trennende Bauteile bekannt, die mit dem Prinzip der kapazitiven Kopplung arbeiten, wobei meist die Eingangsgröße in ein pulsierendes Signal umgewandelt, über Kapazitäten übertragen und zurück in eine Spannung oder einen Strom umgewandelt werden. Diese Bauteile können wie Optokoppler verwendet werden und Details zur Anwendung bei der vorliegenden Erfindung brauchen nicht näher ausgeführt zu werden.

Die galvanische Trennung von Steuer- und Leistungskreis hat weiter den Vorteil, dass die Leistungsseite universell sowohl am negativen als auch am positiven Pol der Versorgung des Leistungskreises angeordnet werden kann. Damit erübrigt sich eine in EP2876509B1 offenbarte Unterscheidung zwischen der Low-Side- und der High-Side-Schaltung.

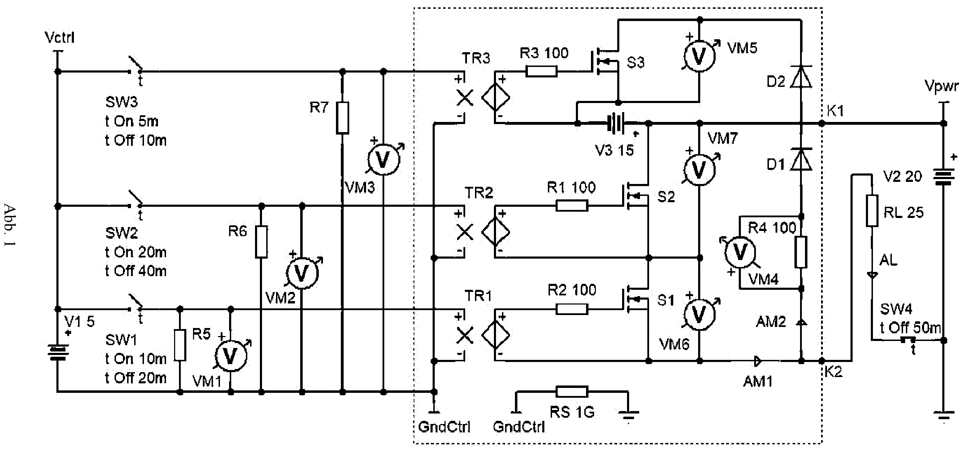

Zum Funktionstest der Schalter des Leistungskreises ist ein Hilfsschalter S3 vorgesehen, mit dem eine Spannung an das Schaltelement unabhängig vom extern angeschlossenen Verbraucher angelegt werden kann. Für ein Halbleiterrelais ohne direkte Verbindung zu beiden Polen der Spannungsversorgung V2 für den Leistungskreis, wie in Abbildung 1 beispielhaft dargestellt, ist eine von V1 galvanisch getrennte Hilfsspannungsquelle V3 vorgesehen. Die Dioden D1 und D2 stellen sicher, dass aufgrund von V3 kein entgegengesetzt gerichteter Strom durch die externe Last RL fließt. Es ist sicherzustellen, dass V3 stets kleiner gleich V1 abzüglich der Flussspannungen von D1 und D2 ist. Dies kann dadurch erreicht werden, dass die Hilfsspannung V3, vorteilhaft im Betrieb abhängig von V2, soweit verringert wird, dass die Spannung VM5 in Abbildung 1 nahe null ist, bevor der Hilfsschalter S3 eingeschaltet wird.

Die Messung des Stromes mit der Messeinrichtung AM2 ist zur Spannungsmessung über den Widerstand R4 mit der Messeinrichtung VM4 äquivalent und kann alternativ umgesetzt sein. Tabelle 1 (am Beschreibungsende) zeigt Schlussfolgerungen, die aus der Strom- oder Spannungsmessung mit den in Abbildung 1 beispielhaft dargestellten Messeinrichtungen resultieren. Wird ein Fehler erkannt, sollte die Einschaltsequenz abgebrochen werden.

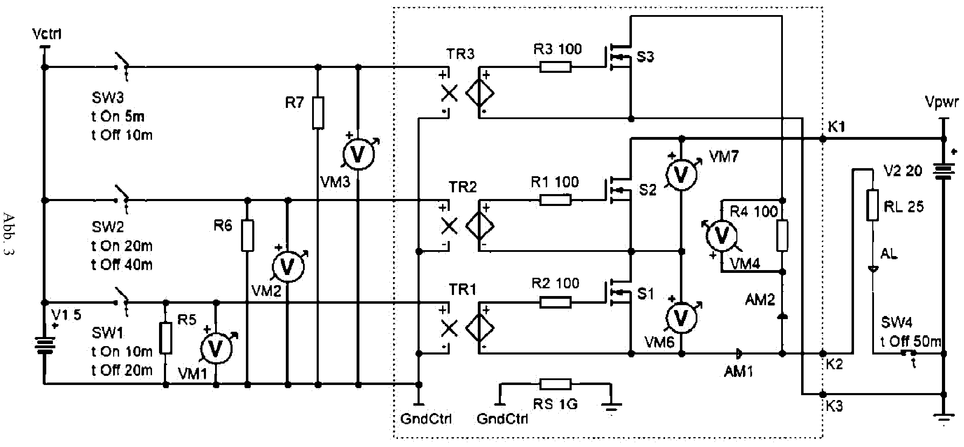

Für ein Halbleiterrelais mit direkter Verbindung zu beiden Polen der Spannungsversorgung V2 für den Leistungskreis, wie in Abbildung 3 beispielhaft dargestellt, ist keine Hilfsspannungsquelle V3 erforderlich. Die Schalter arbeiten fehlerfrei, wenn ein entsprechender Strom AM2 bzw. eine entsprechende Spannung VM4 nur dann vorliegt, wenn alle Schalter einschließlich des Hilfsschalters über die galvanisch trennenden Kopplungen TR1, TR2 und TR3 geschlossen sind. Tabelle 2 (am Beschreibungsende) zeigt Schlussfolgerungen, die aus der Strom- oder Spannungsmessung mit den in Abbildung 3 beispielhaft dargestellten Messeinrichtungen resultieren. Wird ein Fehler erkannt, sollte die Einschaltsequenz abgebrochen werden.

Für eine galvanische Trennung zusätzlich auch mehrerer Leistungskreise untereinander wird für jeden Leistungskreis jeweils ein Schaltelement vorgesehen. Die Schaltelemente je Leistungskreis können optional auch gemeinsam angesteuert werden. Dies ist insbesondere dann vorteilhaft, wenn eine Gruppenschaltung für beispielsweise das synchrone Schalten eines dreiphasigen Wechselstroms vorgesehen ist. Bei der induktiven Kopplung wird dies optional durch eine Primärwicklung auf der Steuer- und je eine Sekundärwicklung für jeden Leistungskreis als Bestandteil des Transformators realisiert.

Besteht ein Schaltelement aus mindestens zwei Schaltern S1 und S2 kann auch die Ansteuerung eines oder mehrerer jedoch nicht aller Schalter, der bzw. die je einem anderen Leistungskreis zugeordnet ist bzw. sind über ein gemeinsames Signal vorteilhaft sein, da das getrennte Schalten der Leistungskreise über den jeweils mindestens einen verbleibenden unabhängigen Schalter des jeweiligen Leistungskreises möglich ist.

Wird der Laststrom gemessen, wie beispielhaft durch die Strommesseinrichtung AM1 in Abbildung 1, Abbildung 3 und Abbildung 9, werden optional und vorteilhaft bei Überschreitung eines eingestellten Grenzwertes die Schaltelemente abgeschaltet. Dies schützt die Last, die Verdrahtung sowie auch die Schalter des Schaltelementes selbst vor Überlast und eine damit verbundene Überhitzung und Zerstörung und dient dem Brandschutz.

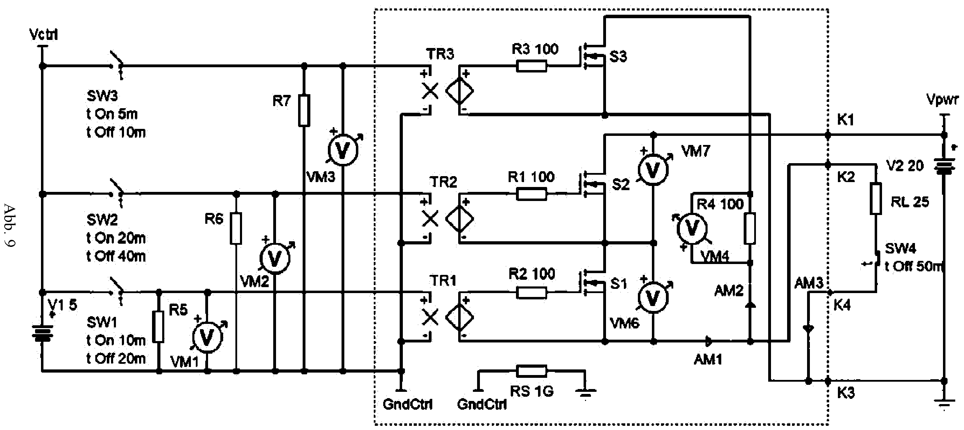

Die Last kann vorteilhaft mit beiden Polen an das Halbleiterrelais angeschlossen werden, wie dies Abbildung 9 beispielhaft zeigt. Der durch die Klemme K4 fließende Strom wird durch die Strommesseinrichtung AM3 und der durch die Klemme K2 fließende Strom wird durch die Strommesseinrichtung AM1 gemessen. Sind beide Ströme (AM1 abzüglich dem Wert von AM2) um beispielsweise mehr als 10% unterschiedlich, ist von einem Fehlerstrom auszugehen. Kurzschlüsse in der Zuleitung zur Last RL zu einem Pol der Versorgungsspannung V2 oder auch ein Querschluss zu einer Zuleitung eines anderen Verbrauchers können die Ursache sein und werden über diesen Mechanismus aufgedeckt. Zur Einsparung von Anschlüssen, Strommesseinrichtungen und Zuleitungen können einzelne Lasten mit einem Pol gemeinsam angeschlossen werden. Der insgesamt zu den Lasten fließende Strom wird mit der Summe der von diesen Lasten zurückfließenden Ströme verglichen. Eine Differenz weist auf vorhandene Fehlerströme hin. Eine genauere Beschreibung des Verfahrens ist EP2876509B1 zu entnehmen.

Im Gesamtsystem sind es die Schaltelemente, die am meisten beansprucht werden und deshalb bevorzugt zum Ausfall neigen. Zur Verringerung der Rate gefährlicher Ausfälle durch ungewollten Schluss auf der Leistungsseite, beispielsweise eine sogenannte Durchlegierung von Emitter und Kollektor bzw. Source und Drain, wird eine Ergänzung um weitere auf der Leistungsseite in Reihe zu S1 und S2 geschaltete Schalter offenbart, die nicht näher dargestellt sind. Diese Schalter werden über zusätzliche Ansteuerbauteile jeweils separat geschaltet oder mehrere Eingänge (Gateanschluss, Basisanschluss) werden auf gemeinsame Ansteuerbauteile parallel geschaltet.

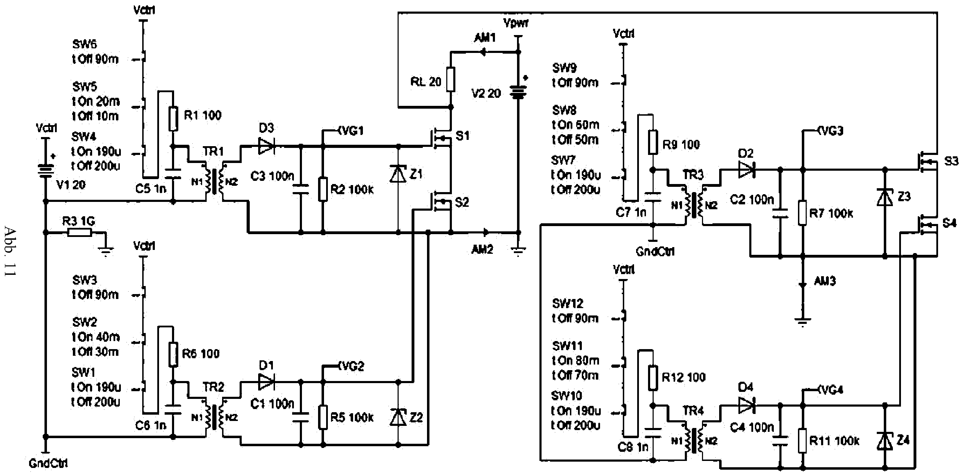

Ist ein Test der Schalter im eingeschalteten Zustand erforderlich, werden mindestens zwei parallele Schaltpfade, jeweils bestehend aus mindestens zwei Schaltern, vorgesehen wie Abbildung 11 veranschaulicht. AM2 und AM3 sind die Strommesseinrichtungen für jeden der Pfade an deren Werte, zusammen mit dem Stromwert der Messeinrichtung AM1 die in EP2876509B1 offenbarten Bedingungen gestellt sind. Besteht jeder der Strompfade aus mehr als zwei Schaltern, wird die Schaltsequenz derart erweitert, dass im eingeschalteten Zustand nur jeweils ein Schalter abgeschaltet wird und somit mindestens ein zweiter Strompfad auf der Leistungsseite durchgeschaltet ist.

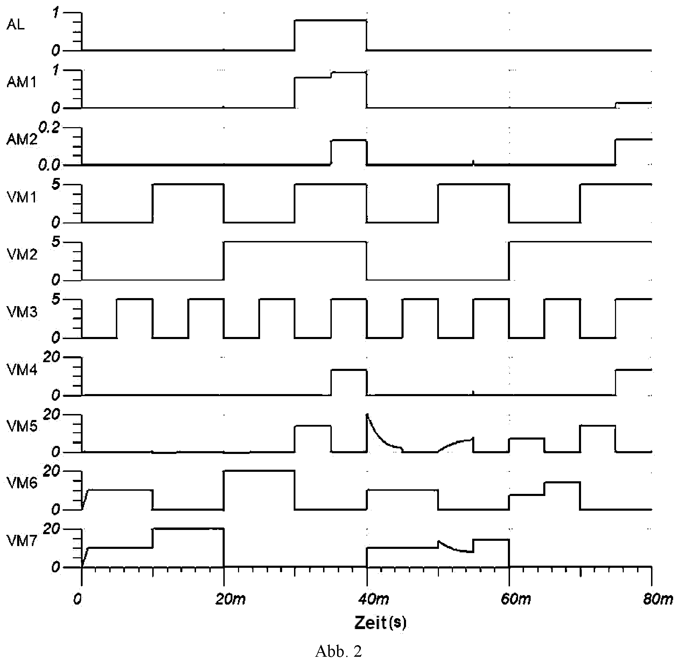

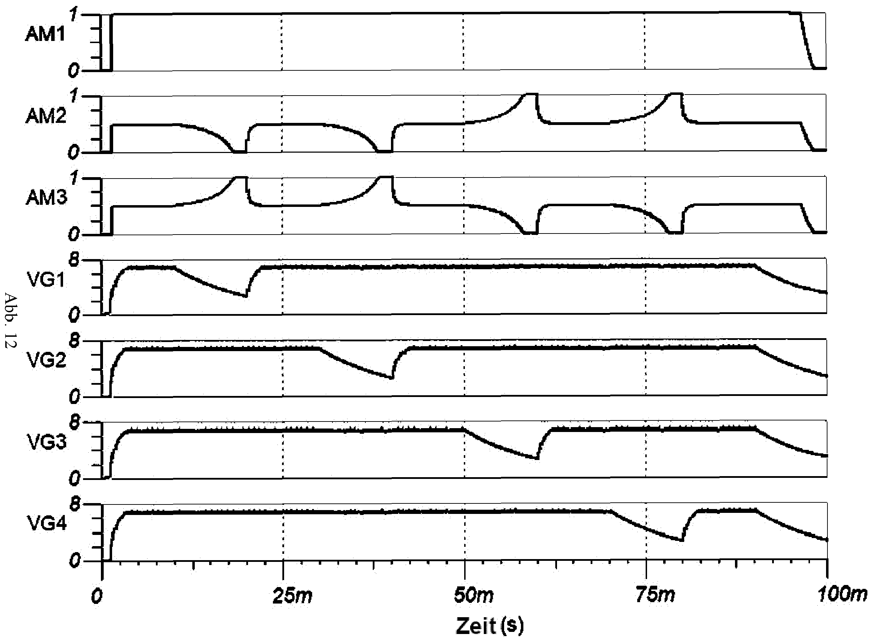

Da die Source-Gate Durchlassspannung von Feldeffekttransistoren und IGBTs eine Exemplarsteuerung aufweist, erfolgt die Ansteuerung mit einem individuell auf das jeweilige Bauteil angepasste Puls-Pausen-Verhältnis. Die pulsierende Spannung wird beispielhaft durch C3 in Abbildung 5 geglättet. Vorteilhaft ist die Einstellung des Puls-Pausen-Verhältnisse derart, dass die Ausschaltdauer, die als Stromunterbrechung in AM2 sowie Spannungsrückgang in VM4 in Abbildung 2 bzw. AM2 und AM3 in Abbildung 12 erkennbar ist, für alle Schalter etwa gleich groß ist.

Zusätzlich ermöglicht eine optional an der Sicherheitssteuerung ergänzte Datenschnittstelle die Ausgabe und damit Verwertung der durch die Strom- und Spannungsmesseinrichtung gemessenen Werte durch weitere nicht näher beschriebene Komponenten. Zusätzlich ermöglicht eine optional an der Sicherheitssteuerung ergänzte Datenschnittstelle die Annahme von Daten und Befehlen von weiteren nicht näher beschriebene Komponenten.

Alle genannten Strom- und Spannungsmesseinrichtungen sind vorteilhaft derart ausgebildet, dass die Messwerte der Steuerseite galvanisch getrennt zur Verfügung stehen. Beispielhaft kann dies mit einem Hall-Stromsensor oder alternativ mit einem Optokoppler und Parallelwiderstand zum lichtaussendenden Element zur Strommessung erfolgen. Für die Spannungsmessung kann dies beispielhaft mit einem Widerstand und einem dazu in Serie geschalteten Optokoppler oder alternativ einem in Serie geschalteten Hall-Stromsensor erfolgen. Weitere Ausführungen wie beispielsweise die Umformung Strom-zu-Spannung, Spannung-zu-Strom, Strom-zu-Frequenz, Spannung-zu-Frequenz jeweils vorteilhaft durch Verwendung eines Operationsverstärkers und anschließenden galvanischen Trennung des Signals durch einen Hall-Stromsensor, Optokoppler oder Transformator sind ebenfalls geeignet, wobei der Transformator nur Wechselströme überträgt. Auch eine kapazitive Kopplung zur galvanisch trennenden Übertragung von Wechselspannung ist möglich.

Die genannten Ausführungen und insbesondere die in den folgenden Abbildungen beschriebenen Prinzipien sind miteinander auf geeignete Weise kombinierbar. Aus Gründen der Übersichtlichkeit stellen insbesondere die Abbildungen jeweils einen Teilaspekt dar.

Abbildung 1 zeigt die wesentlichen Elemente einer beispielhaften Schaltung für ein zweipoliges Halbleiterrelais mit galvanischer Trennung, das mit einem blauen gepunkteten Rahmen umgeben ist und die zwei Anschlüsse K1 und K2 auf der Lastseite aufweist. TR1, TR2 und TR3 sind galvanische trennende Spannungsübertrager. S1 und S2 sind Schalter für den ausgelegten Laststrom. S3 ist ein Hilfsschalter zum Zuschalten der internen Last R4. R1, R2 und R3 sind optionale Vorwiderstände zur Ansteuerung der Schalter. AM1 und AM2 sind Stromsensoren. VM4 und VM5, VM6 und VM7 sind Spannungssensoren. D1 und D2 sind in Reihe geschaltete Dioden. V1 ist die Spannungsversorgung der Steuerseite und V3 eine von V1 galvanisch getrennte Hilfsspannungsquelle. V2 ist die von V1 galvanisch getrennte Spannungsversorgung des Lastkreises. RL ist die externe zu schaltende Last, die sich in Reihe zu V2 und den zwei Anschlüssen K1 und K2 befindet, wobei K1 dem gegenüber K2 positiven Potential zugeordnet ist. SW1, SW2, SW3, SW4, R5, R6, R7, VM1, VM2, VM3, AL und RS sind für die Simulation erforderlich.

Im Zeitraum 0 bis 10 ms sind beide Schalter S1 und S2 abgeschaltet. Im Zeitraum 10 bis 20 ms ist der Schalter S1 ein- und S2 abgeschaltet. Im Zeitraum 20 bis 30 ms ist der Schalter S1 ab- und S2 eingeschaltet. Im Zeitraum 30 bis 40 ms sind beide Schalter S1 und S2 eingeschaltet. Im Zeitraum 50 bis 80 ms ist durch den geöffneten Schalter SW4 keine Last angeschlossen. Für alle Zeiträume ist der Hilfsschalter S3 jeweils für 5 ms ein- und für 5 ms abgeschaltet.

Abbildung 2 zeigt den beispielhaften simulierten Strom- und Spannungsverlauf der Schaltung von Abbildung 1.

Abbildung 3 zeigt die wesentlichen Elemente einer beispielhaften Schaltung für ein dreipoliges Halbleiterrelais mit galvanischer Trennung, das mit einem blauen gepunkteten Rahmen umgeben ist und die drei Anschlüsse K1, K2 und K3 auf der Lastseite aufweist. TR1, TR2 und TR3 sind galvanische trennende Spannungsübertrager. S1 und S2 sind Schalter für den ausgelegten Laststrom. S3 ist ein Hilfsschalter zum Zuschalten der internen Last R4. R1, R2 und R3 sind optionale Vorwiderstände zur Ansteuerung der Schalter. AM1 und AM2 sind Stromsensoren. VM4, VM6 und VM7 sind Spannungssensoren. V1 ist die Spannungsversorgung der Steuerseite. V2 ist die von V1 galvanisch getrennte Spannungsversorgung des Lastkreises. RL ist die externe zu schaltende Last, die sich in Reihe zu V2 und den zwei Anschlüssen K1 und K2 befindet, wobei K1 dem gegenüber K2 positiven Potential zugeordnet ist. K3 ist mit dem negativen Pol von V2 verbunden.

SW1, SW2, SW3, SW4, R5, R6, R7, VM1, VM2, VM3, AL und RS sind für die Simulation erforderlich.

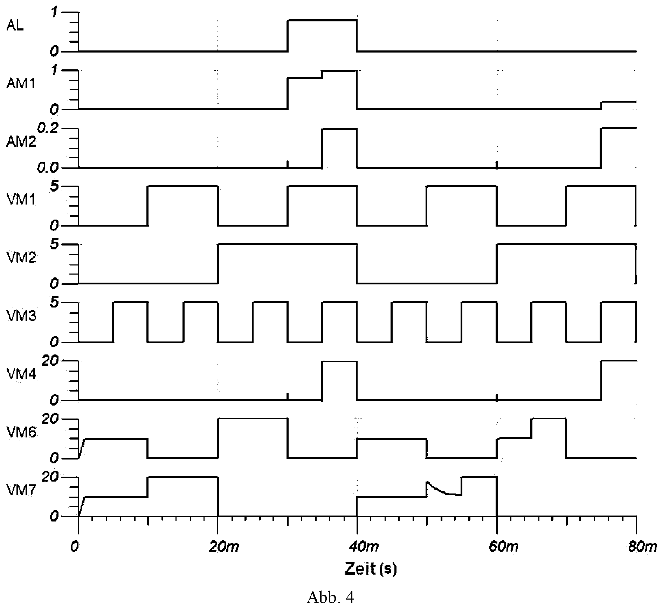

Abbildung 4 zeigt den beispielhaften simulierten Strom- und Spannungsverlauf der Schaltung von Abbildung 3.

Abbildung 5 zeigt die wesentlichen Elemente einer beispielhaften Schaltung für eine galvanische Trennung durch induktive Kopplung. TR1 ist der galvanische trennende induktiv wirkende Übertrager. S1 ist der Schalter für den ausgelegten Laststrom. C4 ist ein Kondensator, der zusammen mit der Primärinduktivität N1 von TR1 einen Schwingkreis bildet. C3 ist ein Kondensator zur Glättung der durch die Diode D3 gleichgerichteten Spannung. Mit dem Widerstand R2 wird eine geeignete Zeitkonstante zur Entladung des Kondensators C3 vorgegeben. Z1 ist eine Zenerdiode zur Spannungsbegrenzung. R1 und R3 sind optionale Vorwiderstände. AM1 ist ein Stromsensor. V1 ist die Spannungsversorgung der Steuerseite. V2 ist die von V1 galvanisch getrennte Spannungsversorgung des Lastkreises. RL ist die externe zu schaltende Last.

SW1, SW2, SW3, VP, VS und RS sind für die Simulation erforderlich.

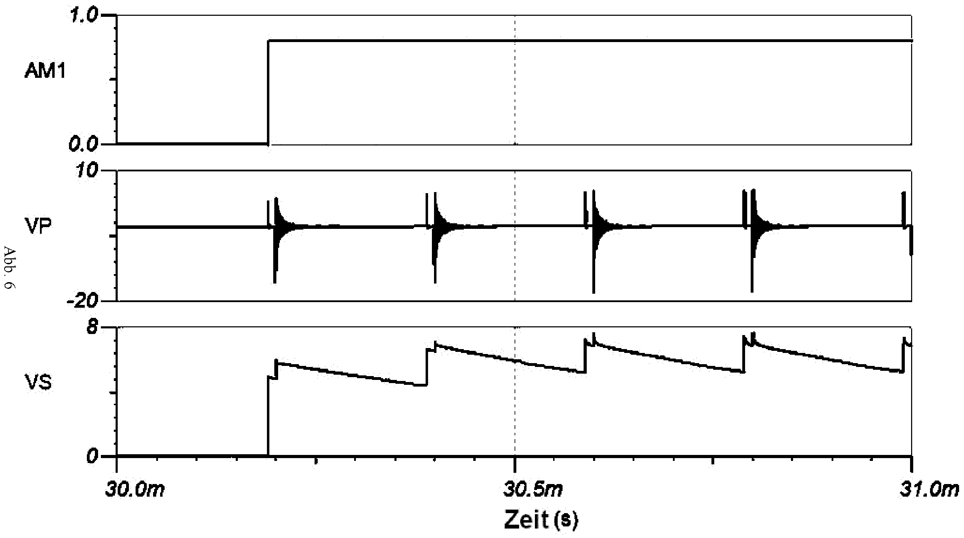

Abbildung 6 zeigt den beispielhaften simulierten Strom- und Spannungsverlauf der Schaltung von Abbildung 5.

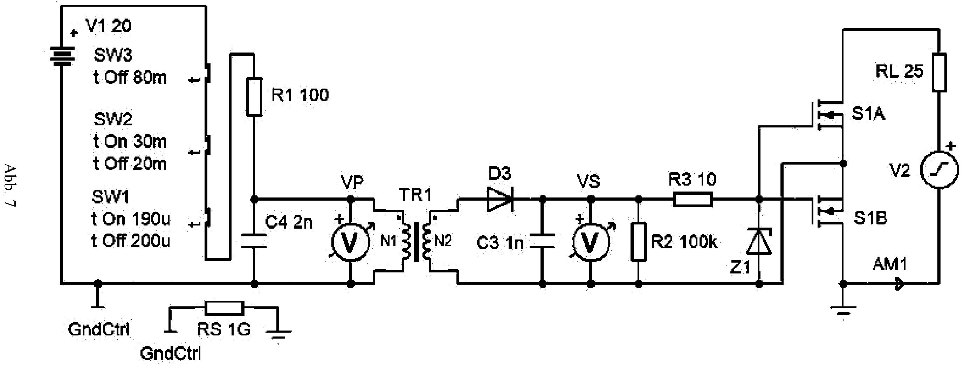

Abbildung 7 zeigt die wesentlichen Elemente einer beispielhaften Schaltung für eine galvanische Trennung durch induktive Kopplung zum Schalten von Wechselstrom. TR1 ist der galvanische trennende induktiv wirkende Übertrager. S1A und S1B sind die Schalter für den Laststrom und dazu ausgelegt, wenigstens eine der zwei Polaritäten der anliegenden Spannung abzuschalten. C4 ist ein Kondensator, der zusammen mit der Primärinduktivität N1 von TR1 einen Schwingkreis bildet. C3 ist ein Kondensator zur Glättung der durch die Diode D3 gleichgerichteten Spannung. Mit dem Widerstand R2 wird eine geeignete Zeitkonstante zur Entladung des Kondensators C3 vorgegeben. Z1 ist eine Zenerdiode zur Spannungsbegrenzung. R1 und R3 sind optionale Vorwiderstände. AM1 ist ein Stromsensor. V1 ist die Spannungsversorgung der Steuerseite. V2 ist die von V1 galvanisch getrennte Spannungsversorgung des Lastkreises. RL ist die externe zu schaltende Last.

SW1, SW2, SW3, VP, VS und RS sind für die Simulation erforderlich.

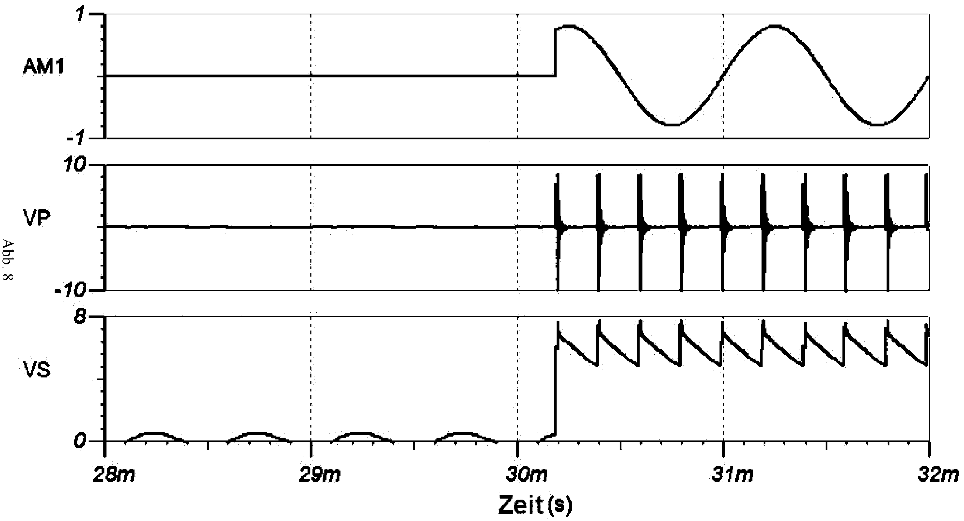

Abbildung 8 zeigt den beispielhaften simulierten Strom- und Spannungsverlauf der Schaltung von Abbildung 7.

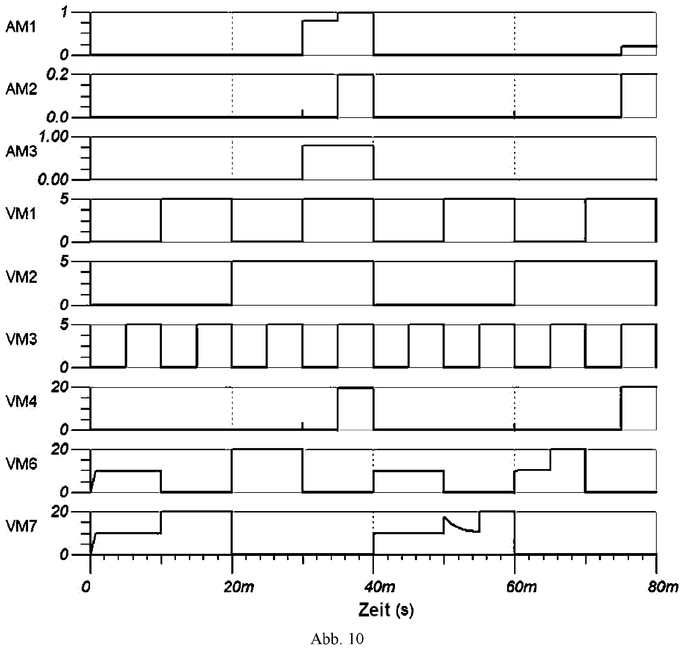

Abbildung 9 zeigt die wesentlichen Elemente einer aus Abbildung 3 abgeleiteten beispielhaften Schaltung, wobei die Last an den Klemmen K2 und K4 angeschlossen wird und die Ströme an diesen Klemmen durch den zusätzlichen Stromsensor AM3 miteinander ins Verhältnis gesetzt werden können. Abbildung 10 zeigt den beispielhaften simulierten Strom- und Spannungsverlauf der Schaltung von Abbildung 9.

Abbildung 11 zeigt die wesentlichen Elemente einer beispielhaften Schaltung für die galvanisch getrennte Ansteuerung parallel geschalteter Schaltelemente. TR1, TR2, TR3 und TR4 sind galvanische trennende induktiv wirkende Übertrager. S1, S2, S3 und S4 sind Schalter für den ausgelegten Laststrom. C5, C6, C7 bzw. C8 sind Kondensatoren, die zusammen mit der jeweiligen Primärinduktivität N1 von TR1, TR2, TR3 bzw. TR4 einen Schwingkreis bilden. C1, C2, C3 bzw. C4 sind Kondensatoren zur Glättung der durch die Dioden D1, D2, D3 bzw. D4 gleichgerichteten Spannung. Mit den Widerständen R2, R5, R7 bzw. R11 wird eine geeignete Zeitkonstante zur Entladung der Kondensatoren C1, C2, C3 bzw. C4 vorgegeben. Z1, Z2, Z3 und Z4 sind Zenerdioden zur Spannungsbegrenzung. R1, R6, R9 und R12 sind optionale Vorwiderstände. AM1, AM2 und AM3 sind Stromsensoren. V1 ist die Spannungsversorgung der Steuerseite. V2 ist die von V1 galvanisch getrennte Spannungsversorgung des Lastkreises. RL ist die externe zu schaltende Last. Nicht dargestellt ist der Hilfsschalter zum Zuschalten der internen Last, wie in Abbildung 1, Abbildung 3 sowie Abbildung 9 bereits ausgeführt.

SW1 bis SW12 und VG1 bis VG4 sind für die Simulation erforderlich.

Abbildung 12 zeigt den beispielhaften simulierten Strom- und Spannungsverlauf der Schaltung von Abbildung 11. Die gezeigten Sequenzen sind beispielhaft. Eine zeitliche Umsortierung der Sequenzteile kann je nach Anwendungsfall vorteilhaft sein und wird ausdrücklich offenbart.

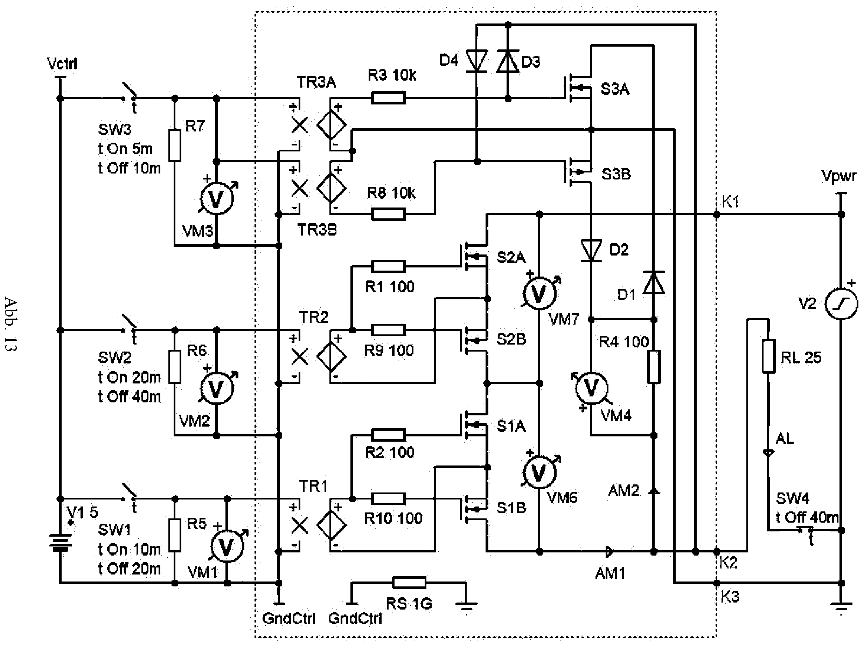

Abbildung 13 zeigt die wesentlichen Elemente einer beispielhaften Schaltung für ein dreipoliges Halbleiterrelais mit galvanischer Trennung für Wechselspannung, das mit einem blauen gepunkteten Rahmen umgeben ist und die drei Anschlüsse K1, K2 und K3 auf der Lastseite aufweist. TR1, TR2, TR3A und TR3B sind galvanische trennende Spannungsübertrager. S1A, S1B, S2A und S2B sind Schalter für den ausgelegten Laststrom. S3A und S3B sind Hilfsschalter zum Zuschalten der internen Last R4. D1 bzw. D2 sind Dioden zur Stromunterdrückung über die jeweilige Body-Diode von S3A bzw. S3B. D3 bzw. D4 sind Dioden zur Sperrung der Schalter S3A bzw. S3B, abhängig von der Polarität der Lastkreisspannung V2. R1, R2, R3, R8, R9 und R10 sind optionale Vorwiderstände zur Ansteuerung der Schalter. AM1 und AM2 sind Stromsensoren. VM4, VM6 und VM7 sind Spannungssensoren. V1 ist die Spannungsversorgung der Steuerseite. V2 ist die von V1 galvanisch getrennte Spannungsversorgung des Lastkreises. RL ist die externe zu schaltende Last, die sich in Reihe zu V2 und den zwei Anschlüssen K1 und K2 befindet, wobei K1 dem gegenüber K2 positiven Potential zugeordnet ist. K3 ist mit dem negativen Pol von V2 verbunden.

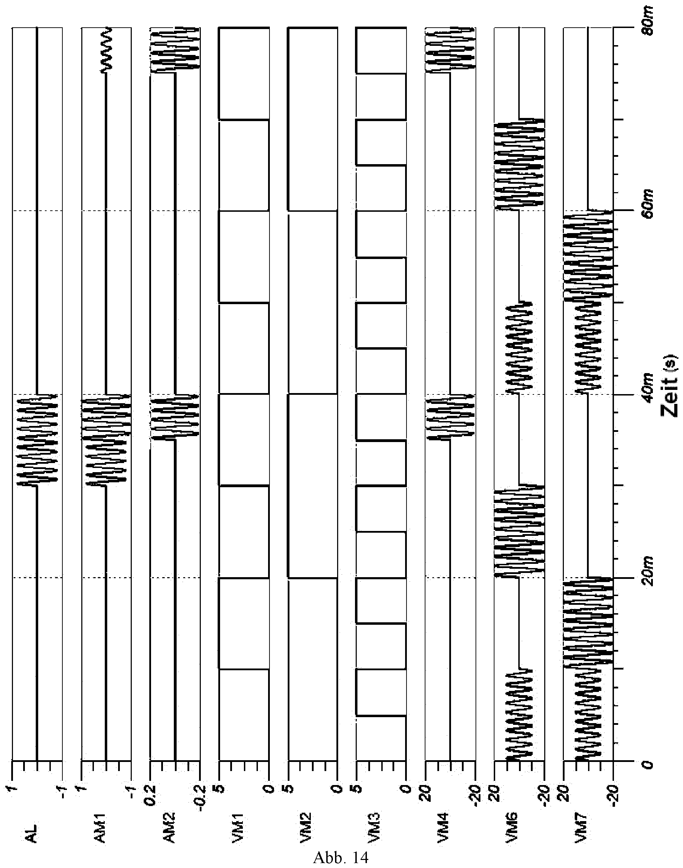

Abbildung 14 zeigt den beispielhaften simulierten Strom- und Spannungsverlauf der Schaltung von Abbildung 13.

Die obige Beschreibung bezieht sich auf beiliegende Zeichnungen, wobei jeweils zeigen:
Abbildung 1: Halbleiterrelais 2-polig mit galvanischer Trennung
Abbildung 2: Strom- und Spannungsverlauf der simulierten Schaltung von Abbildung 1
Abbildung 3: Halbleiterrelais 3-polig mit galvanischer Trennung
Abbildung 4: Strom- und Spannungsverlauf der simulierten Schaltung von Abbildung 3
Abbildung 5: Beispielhafte Schaltung für eine galvanische Trennung durch induktive Kopplung
Abbildung 6: Strom- und Spannungsverlauf der simulierten Schaltung von Abbildung 5
Abbildung 7: Beispielhafte Schaltung für eine galvanische Trennung durch induktive Kopplung zum Schalten von Wechselstrom
Abbildung 8: Strom- und Spannungsverlauf der simulierten Schaltung von Abbildung 7
Abbildung 9: Halbleiterrelais 4-polig mit galvanischer Trennung
Abbildung 10: Strom- und Spannungsverlauf der simulierten Schaltung von Abbildung 9
Abbildung 11: Galvanisch getrennte Ansteuerung parallel geschalteter Schaltelemente
Abbildung 12: Strom- und Spannungsverlauf der simulierten Schaltung von Abbildung 11
Abbildung 13: Halbleiterrelais 3-polig mit galvanischer Trennung für Wechselspannung
Abbildung 14: Strom- und Spannungsverlauf der simulierten Schaltung von Abbildung 13

Die Beschreibung umfasst weiterhin folgende Tabellen:

**Tabelle 1: Vorteilhafte Einschaltsequenz für das zweipolige Halbleiterrelais (Abbildung 1), 0 = Aus bzw. nahe null, 1 = Ein, V2 = Spannung V2, freies Feld = nicht relevant**

| Schalter | | | Stromerwart ung | | Spannungserwartung | | | | Bemerkung |
|---|---|---|---|---|---|---|---|---|---|
| S1 | S2 | S3 | AM1 | AM2 | VM4 | VM5 | VM6 | VM7 | |
| 0 | 0 | 0 | 0 | 0 | | | | | kein Fehler erkannt |
| | | | | | 0 | | ½ V2 | ½ V2 | |
| 0 | 0 | 0 | | 0 | 0 | > 0 | | | V3 zu hoch |
| 0 | 0 | 0 | | > 0 | | | | | Kurzschluss S1, S2 und S3 |
| | | | | | > 0 | | | | |
| 0 | 0 | 1 | | > 0 | | | | | Kurzschluss S1 und S2 |
| | | | | | > 0 | | | | |
| 0 | 1 | 1 | | > 0 | | | | | Kurzschluss S1 |
| | | | | | > 0 | | | | |
| 1 | 0 | 1 | | > 0 | | | | | Kurzschluss S2 |
| | | | | | > 0 | | | | |
| 1 | 0 | | | | | | 0 | V2 | externe Lastspannung |
| 0 | 1 | | | | | | V2 | 0 | |
| 1 | 1 | 1 | | 0 | | | | | interner Fehler |
| | | | | | 0 | | | | |
| 1 | 1 | 1 | | > 0 | | | 0 | 0 | kein Fehler erkannt |
| | | | | | > 0 | | | | |
| 1 | 1 | | AM1 - AM2 | | | | | | externer Laststrom |
| 1 | 1 | 0 | | > 0 | | | | | Kurzschluss S3 |
| | | | | | > 0 | | | | |

**Tabelle 2: Vorteilhafte Einschaltsequenz für das dreipolige Halbleiterrelais (Abbildung 3), 0 = Aus bzw. nahe null, 1 = Ein, V2 = Spannung V2, freies Feld = nicht relevant**

| Schalter | | | Stromerwartu ng | | Spannungserwartung | | | Bemerkung |
|---|---|---|---|---|---|---|---|---|
| S1 | S2 | S3 | AM1 | AM2 | VM4 | VM6 | VM7 | |
| 0 | 0 | 0 | 0 | 0 | | | | kein Fehler erkannt |
| | | | | | 0 | ½ V2 | ½ V2 | |
| 0 | 0 | 0 | | > 0 | | | | Kurzschluss S1, S2 |
| | | | | | > 0 | | | und S3 |
| 0 | 0 | 1 | | > 0 | | | | Kurzschluss S1 und S2 |
| | | | | | > 0 | | | |
| 0 | 1 | 1 | | > 0 | | | | Kurzschluss S1 |
| | | | | | > 0 | | | |
| 1 | 0 | 1 | | > 0 | | | | Kurzschluss S2 |
| | | | | | > 0 | | | |
| 1 | 0 | | | | | 0 | V2 | externe Lastspannung |
| 0 | 1 | | | | | V2 | 0 | |
| 1 | 1 | 1 | | 0 | | | | interner Fehler |
| | | | | | 0 | | | |
| 1 | 1 | 1 | | > 0 | | 0 | 0 | kein Fehler erkannt |
| | | | | | > 0 | | | |
| 1 | 1 | | AM1 - AM2 | | | | | externer Laststrom |
| 1 | 1 | 0 | | > 0 | | | | Kurzschluss S3 |
| | | | | | > 0 | | | |

## Patentansprüche

1. Sicherheitsschaltgerät, ausgelegt zum gemäß einer Sicherheitsvorschrift sicheren Ein- und Ausschalten eines elektrischen Verbrauchers, umfassend einen Leistungskreis mit zumindest zwei in Reihe geschalteten Halbleiterschaltelementen, einem Ausgang, an den der elektrische Verbraucher unter Bildung eines mittels der Halbleiterschaltelemente sicher schaltbaren Versorgungsstromkreises für den elektrischen Verbraucher anschließbar ist, weiter umfassend ein Mess- und Auswertesystem zur Prüfung der Funktionalität der Halbleiterschaltelemente mittels Spannungsmessgeräten, ausgebildet zur Messung der Spannung über das jeweilige Halbleiterschaltelement, **gekennzeichnet durch** ein Schaltelement (S3) zur Bildung eines Strompfades parallel zum Verbraucher, welcher die Halbleiterschaltelemente umfasst, und wobei die Schaltkontakte der Halbleiterschaltelemente galvanisch getrennt angesteuert sind.

2. Sicherheitsschaltgerät nach dem vorhergehenden Anspruch, bei dem auch der Schaltkontakt des Schaltelements (S3) galvanisch getrennt angesteuert ist und/oder wobei auch das Schaltelement (S3) als Halbleiterschaltelement ausgebildet ist.

3. Sicherheitsschaltgerät nach einem der vorhergehenden Ansprüche, bei dem die galvanisch trennende Ansteuerung der Halbleiterschaltelemente und/oder des Schaltelements (S3) induktiv erfolgt, indem jeweils ein Steuerkreis eine Induktivität umfasst, die mit einem pulsierenden Strom versorgt wird, und eine zweite Induktivität, die mit der ersten magnetisch gekoppelt ist, das jeweilige Halbleiterschaltelement oder den Schalter (S3) ansteuert.

4. Sicherheitsschaltgerät nach einem der vorhergehenden Ansprüche, bei dem die galvanisch trennende Ansteuerung der Halbleiterschaltelemente und/oder des Schaltelements (S3) optisch erfolgt, indem jeweils ein Steuerkreis ein lichtemittierendes Element umfasst, und ein lichtempfindliches Element, das mit dem lichtemittierenden Element optisch gekoppelt ist und das jeweilige Halbleiterschaltelement oder den Schalter (S3) ansteuert.

5. Sicherheitsschaltgerät nach einem der vorhergehenden Ansprüche, bei dem das jeweilige Halbleiterschaltelement und/oder das Schaltelement (S3) dazu ausgelegt ist, beide Polaritäten der anliegenden Spannung abzuschalten.

6. Sicherheitsschaltgerät nach einem der vorhergehenden Ansprüche, bei dem der durch das Schaltelement (S3) gebildete Strompfad parallel zum Verbraucher, welcher die Halbleiterschaltelemente umfasst, eine eigene Spannungsquelle umfasst.

7. Sicherheitsschaltgerät nach einem der Ansprüche 1 bis 5, weiter umfassend einen Anschluss (K3) zum Anschluss einer externen Spannungsquelle des Verbrauchers, welcher Teil des durch das Schaltelement (S3) gebildeten Strompfades parallel zum Verbraucher ist, welcher die Halbleiterschaltelemente umfasst.

8. Sicherheitsschaltgerät nach einem der vorhergehenden Ansprüche, bei dem das jeweilige Halbleiterschaltelement zwei gegenpolig in Reihe geschaltete Schalter, insbesondere Feldeffekttransistoren umfasst.

9. Sicherheitsschaltgerät nach einem der vorhergehenden Ansprüche, umfassend eine Mehrzahl gleichartiger Leistungskreise zum Schalten mehrerer Verbraucher.

10. Sicherheitsschaltgerät nach Anspruch 9, bei dem mehrere der Leistungskreise einem gemeinsamen Steuerkreis zugeordnet sind.

11. Sicherheitsschaltgerät nach einem der vorhergehenden Ansprüche, bei dem das Mess- und Auswertesystem dazu ausgebildet ist, den über den Verbraucher fließenden Strom zu messen und bei Überschreitung eines voreingestellten Grenzwertes ein Halbleiterschaltelement des jeweiligen Leistungskreises abzuschalten.

12. Sicherheitsschaltgerät nach Anspruch 9 und 11, bei dem das Mess- und Auswertesystem dazu ausgebildet ist, bei Überschreitung eines voreingestellten Grenzwertes ein Halbleiterschaltelement eines oder mehrerer weiterer Leistungskreise abzuschalten.

13. Sicherheitsschaltgerät nach einem der vorhergehenden Ansprüche, weiter umfassend eine Datenschnittstelle, die dazu ausgelegt ist, durch das Mess- und Auswertesystem gemessene Ströme und/oder Spannungen zur Verfügung zu stellen.

14. Sicherheitsschaltgerät nach Anspruch 13, bei dem die Datenschnittstelle weiter dazu ausgelegt ist, Daten und Befehle von externen Komponenten zu empfangen und zu verarbeiten.
